# EUROPEAN PATENT APPLICATION

(11) **EP 4 632 804 A2**
(43) Date of publication of application: **15.10.2025**
(21) Application number: 25165173.3
(22) Date of filing: 20.03.2025
(51) Int. Cl.: H01L 23/051, H01L 23/36, H01L 23/538, H01L 25/07, H01L 25/11

(54) **POWER MODULE AND POWER DEVICE**

(30) Priority: 08.04.2024 CN 202410420190
(71) Applicant: Huawei Digital Power Technologies Co., Ltd., Shenzhen, Guangdong 518043 (CN)
(72) Inventor: Ouyang, Mize, Shenzhen, 518043 (CN); Peng, Hao, Shenzhen, 518043 (CN); Liu, Zhiling, Shenzhen, 518043 (CN); Wang, Junhe, Shenzhen, 518043 (CN)
(74) Representative: Gill Jennings & Every LLP

(57) **Abstract**

Embodiments of this application relate to the field of semiconductor packaging technologies, and provide a power module and a power device, to reduce parasitic inductance in the power module. The power module includes a first conductive plate, a second conductive plate, a third terminal, a first power transistor, and a second power transistor. A part of the first conductive plate serves as a first terminal. The second conductive plate is stacked with the first conductive plate, where a part of the second conductive plate serves as a second terminal. The third terminal is located on a side that is of the first conductive plate and that faces the second conductive plate, and is insulated from the second conductive plate. The third terminal is stacked with the first terminal. The first power transistor is disposed between the first conductive plate and the second conductive plate. A first electrode of the first power transistor is electrically connected to the first conductive plate, and a second electrode of the first power transistor is electrically connected to the second conductive plate. A first electrode of the second power transistor is electrically connected to the second conductive plate, and a second electrode of the second power transistor is electrically connected to the third terminal.

## Description

### TECHNICAL FIELD

The present invention relates to the field of semiconductor packaging technologies, and in particular, to a power module and a power device.

### BACKGROUND

Compared with single-transistor package, a power module that integrates a plurality of power transistors features high integration, easy assembly, and high reliability.

However, a large quantity of power transistors in the power module result in a complex structure, and parasitic inductance in the power module increases and can no longer be ignored. Especially, as a turn-on and turn-off speed and a power output of a semiconductor element in the power module are increasingly increased, when the power transistor is turned off, the parasitic inductance generated in the power module is large. The generated parasitic inductance induces a high voltage, which increases a voltage stress of the power transistor, and may damage the power transistor, and the like of the power module, reducing reliability of the power module.

### SUMMARY

An objective of this application is to provide a power module and a power device, to reduce parasitic inductance in the power module and improve reliability of the power module.

According to a first aspect of embodiments of this application, a power module is provided, including a first conductive plate, a second conductive plate, a third terminal, a first power transistor, and a second power transistor. A part of the first conductive plate serves as the first terminal. The second conductive plate is stacked with the first conductive plate, where a part of the second conductive plate serves as a second terminal. The third terminal is located on a side that is of the first conductive plate and that faces the second conductive plate, and is insulated from the second conductive plate. The third terminal is stacked with the first terminal. The first power transistor is disposed between the first conductive plate and the second conductive plate. A first electrode of the first power transistor is electrically connected to the first conductive plate, and a second electrode of the first power transistor is electrically connected to the second conductive plate. The second power transistor is disposed on the second conductive plate. A first electrode of the second power transistor is electrically connected to the second conductive plate, and a second electrode of the second power transistor is electrically connected to the third terminal.

When the power module works, the first power transistor and the second power transistor are alternatively in a turn-on state, and are connected to a battery through the first terminal and the third terminal. After a direct current is converted into an alternating current via the power module, the alternating current is output through the second terminal. Alternatively, an alternating current is input to the second terminal, and after the power module converts the alternating current into a direct current, the direct current is output through the first terminal and the third terminal. In this case, the direct current flows through the first conductive plate, the first power transistor, the second conductive plate, the second power transistor, and the third terminal.

In other words, when the power module works, a current needs to flow through the first power transistor and the second power transistor. In a related technology, the first power transistor and the second power transistor are connected to each other through a bonding wire. Because the bonding wire used in a process is usually of a curve structure, a length of the bonding wire is greater than a straight-line distance between two connection points. Therefore, in a connection manner using a bonding wire, the bonding wire is long, and a path of a current passing through the bonding wire is long, resulting in large parasitic inductance.

In the power module provided in this embodiment of this application, the second electrode of the first power transistor is electrically connected to the first electrode of the second power transistor through the second conductive plate. In this case, most of the current flows between a joint between the second electrode of the first power transistor and the second conductive plate and a joint between the first electrode of the second power transistor and the second conductive plate. That is, most of the current flows in a vertical path between the joint between the second electrode of the first power transistor and the second conductive plate and joint between the first electrode of the second power transistor and the second conductive plate. Compared with connection using a bonding wire of a curve structure, connection using the second conductive plate has a shorter current path, and smaller parasitic inductance when a current flows in the second conductive plate of a plate-shaped structure. In this way, the parasitic inductance of the power module is reduced, and a voltage stress of a semiconductor element is reduced, to prevent the first power transistor or the second power transistor from being damaged due to excessively large voltage pressure, and improve reliability of the power module. In addition, the third terminal is insulated from the second conductive plate, to prevent a short circuit caused by direct transmission of a current from the second conductive plate to the third terminal without passing through the second power transistor. The first terminal is stacked with the third terminal. Compared with a structure in which the first terminal and the third terminal are located in different areas in a direction parallel to the first conductive plate, a structure in which the first terminal is stacked with the third terminal occupies smaller space in the direction parallel to the first conductive plate. In this way, a width of the power module can be reduced, to optimize a structural layout of the power module and reduce a size of the power module.

In some embodiments of this application, the second power transistor is disposed between the first conductive plate and the second conductive plate. A vertical projection of the first power transistor on the second conductive plate does not overlap a vertical projection of the second power transistor on the second conductive plate. In this case, a thickness of the first power transistor coincides with a thickness of the second power transistor, so that a total thickness of the power module can be reduced. In addition, the second power transistor and the first power transistor are located at different positions between the first conductive plate and the second conductive plate, so that thermal coupling between a wafer of the second power transistor and a wafer of the first power transistor can be reduced. Therefore, a thermal reliability failure caused by a high heat flux density is avoided.

In some embodiments of this application, the power module further includes a third conductive plate. A second electrode of the second power transistor and the third terminal are electrically connected to the third conductive plate respectively. The first conductive plate may be provided with an avoidance hole that penetrates the first conductive plate, the third conductive plate is disposed in the avoidance hole, and the third conductive plate is insulated from the first conductive plate. The third terminal is stacked with the first conductive plate, and is electrically connected to the third conductive plate. After the second electrode of the second power transistor is electrically connected to the third conductive plate, and the second power transistor, the third conductive plate, and the third terminal are connected to each other, so that the second electrode of the second power transistor is electrically connected to the third terminal. In addition, the third conductive plate is insulated from the first conductive plate, to prevent a short circuit caused by direct transmission of a current from the first conductive plate to the third terminal through the third conductive plate without passing through the first power transistor and the second power transistor. In some embodiments of this application, the second power transistor is located on a side that is of the first power transistor and that faces the third terminal. In this case, the second power transistor is located between the first power transistor and the third terminal, and a current is transmitted from the first power transistor to the second conductive plate. The current is further transmitted to the third terminal through the second power transistor after passing through the second conductive plate, or the current is transmitted from the third terminal to the second conductive plate through the second power transistor. The current is further transmitted to the first power transistor through the second conductive plate. In this case, the current needs to pass through the second power transistor. When the second power transistor through which the current flows is located between the first power transistor and the third terminal, a total current path is short, so that parasitic inductance is reduced and reliability of the power module is improved.

In some embodiments of this application, the power module further includes a first conductive pillar. The first conductive pillar is disposed between the third terminal and the third conductive plate, where two ends of the first conductive pillar are electrically connected to the third terminal and the third conductive plate respectively. The first conductive pillar is disposed on a side that is of the third conductive plate and that is away from the first conductive plate, so that a distance between the third conductive plate and the third terminal is increased. In other words, a distance between the third terminal and the first conductive plate in a thickness direction of the power module is increased, so that there may be a gap between the third terminal and the first conductive plate, and direct electrical connection between the third terminal and the first conductive plate is avoided.

In some embodiments of this application, the power module includes at least two second power transistors, at least two third terminals, and at least two first conductive pillars. The third terminal is electrically connected to the second power transistor through at least one first conductive pillar. When the current flows between the second power transistor and the battery, most of the current flows through a shortest current path in a case in which the second power transistor is connected to the battery. In this case, different second power transistors may be connected to the battery through the first conductive pillar and the third terminal that are close to the second power transistors. In this way, a current path is further reduced. Therefore, the parasitic inductance is reduced and the reliability of the power module is improved.

In some embodiments of this application, the second conductive plate includes a third body part and a second terminal electrically connected to the third body part. After a direct current is converted into an alternating current via the power module, the alternating current can be output through the second terminal of the second conductive plate. Alternatively, an alternating current is input to the second terminal, and after the alternating current is converted into a direct current via the power module, the direct current is output through the first terminal and the second terminal.

In some other embodiments of this application, the third conductive plate is stacked on a side that is of the second conductive plate and that is away from the first conductive plate, and a part of the third conductive plate serves as the third terminal. The second power transistor is disposed between the second conductive plate and the third conductive plate. The first electrode of the second power transistor is electrically connected to the second conductive plate. The second electrode of the second power transistor is electrically connected to the third conductive plate. The second electrode of the first power transistor is electrically connected to the first electrode of the second power transistor through the second conductive plate. In this case, most of the current flows between a joint between the second electrode of the first power transistor and the second conductive plate and a joint between the first electrode of the second power transistor and the second conductive plate. Therefore, a current path is short, and parasitic inductance is small.

In some embodiments of this application, the power module further includes an insulation layer. The insulation layer is disposed between the first conductive plate and the second conductive plate, and between the first terminal and the third terminal, where at least a part of the first terminal and at least a part of the third terminal are exposed from the insulation layer. A part that is of the first terminal and that is exposed from the insulation layer and a part that is of the third terminal and that is exposed from the insulation layer are connected to another component (for example, a circuit board). Through the insulation layer, the first terminal and the third terminal are ensured to be not directly conducted, and electrical insulation protection is provided for a peripheral side of the first power transistor. That is, the insulation layer can provide good electrical insulation protection for the power module. In addition, the insulation layer also can provide a support function to provide mechanical strength protection for the power module.

In some embodiments of this application, the insulation layer is further disposed on a peripheral side of the first conductive plate and a peripheral side of the third terminal. In this case, the insulation layer can ensure that the peripheral side of the first conductive plate and the peripheral side of the third terminal are insulated from the outside, and a creepage distance between the first conductive plate and the edge part of the third terminal can be increased to prevent a creepage phenomenon. Therefore, electrical safety performance is improved, and a safety requirement is met.

In some embodiments of this application, the insulation layer is further disposed between the second conductive plate and the third conductive plate, and between the third conductive plate and the first conductive plate. Through the insulation layer, insulation between the third conductive plate and the first conductive plate is ensured, and good electrical insulation protection is provided.

In some embodiments of this application, the power module includes a first connection hole. The first connection hole penetrates the first terminal, the insulation layer, and the third terminal. The first connection hole is configured to accommodate a fastening member. The fastening member accommodated in the first connection hole supports the first terminal and the third terminal, to prevent a short circuit caused by direct electrical connection between the first terminal and the third terminal after the first terminal and the third terminal are close to each other due to force applied on the power module.

In some embodiments of this application, the first connection hole is located at the insulation layer and penetrates the insulation layer. The first conductive plate includes a first body part and the first terminal electrically connected to the first body part. The first terminal is provided with a second connection hole that penetrates the first terminal, the first connection hole communicates with the second connection hole, and the second connection hole is exposed from the first connection hole. The third terminal is provided with a third connection hole that penetrates the third terminal, the first connection hole communicates with the third connection hole, and the third connection hole is exposed from the first connection hole. In this case, the first connection hole can accommodate the fastening member, and the second connection hole and the third connection hole are respectively configured to accommodate two ends of the fastening member. In addition, after the fastening member is disposed in the first connection hole, an insulation layer is disposed between the fastening member and the first terminal, and between the fastening member and the third terminal, to prevent the first terminal and the third terminal from being conducted via the fastening member. In this way, a short circuit is avoided.

In some embodiments of this application, the power module further includes a plurality of first conductive strips. The plurality of first conductive strips are sequentially spaced from each other. Each first conductive strip is disposed on a side that is of the first power transistor and that faces the second conductive plate. The power module further includes a plurality of second conductive strips. The plurality of second conductive strips are sequentially spaced from each other. Each second conductive strip is disposed on a side that is of the second power transistor and that faces the third conductive plate. Heat dissipated when the first power transistor works may be further transmitted to the first conductive strip, so that heat of the first power transistor is dissipated. Similarly, heat dissipated when the second power transistor works may be further transmitted to the second conductive strip, so that heat of the second power transistor is dissipated. In this way, a thermal reliability failure of the first power transistor and the second power transistor is improved.

In some embodiments of this application, an end that is of the second conductive plate and that faces the first power transistor has a plurality of first protruding parts, and the first protruding part is electrically connected to at least one first conductive strip. The power module further includes a plurality of first heat dissipation strips. The plurality of first heat dissipation strips are located between the first conductive strip and the second conductive plate, where the plurality of first heat dissipation strips are alternately disposed between two adjacent first protruding parts. The first protruding part is electrically connected to the first conductive strip, so that the first conductive strip is electrically connected to the second conductive plate. Heat dissipated when the first power transistor works is transferred to the first heat dissipation strip disposed between two adjacent first protruding parts through the first conductive strip, and heat is dissipated through the first heat dissipation strip, so that a thermal reliability failure of the first power transistor is further improved.

In some embodiments of this application, an insulation layer is further disposed between the first heat dissipation strip and the first protruding part, and between the first heat dissipation strip and the first conductive strip. The first heat dissipation strip and the first protruding part are insulated from each other through the insulation layer, and the first heat dissipation strip and the first conductive strip are insulated from each other through the insulation layer. In this way, a short circuit is prevented between different first conductive strips.

In some embodiments of this application, an end that is of the third conductive plate and that faces the second power transistor has a plurality of second protruding parts, and the second protruding part is electrically connected to at least one second conductive strip. The power module further includes a plurality of second heat dissipation strips. The plurality of second heat dissipation strips are located between the second conductive strip and the third conductive plate, where the plurality of second heat dissipation strips are alternately disposed between two adjacent second protruding parts. The second protruding part is electrically connected to the second conductive strip, so that the second conductive strip is electrically connected to the third conductive plate. Heat dissipated when the second power transistor works is transferred to the second heat dissipation strip disposed between two adjacent second protruding parts through the second conductive strip and the insulation layer, and heat is dissipated through the second heat dissipation strip, so that a thermal reliability failure of the second power transistor is further improved.

In some embodiments of this application, an insulation layer is further disposed between the second heat dissipation strip and the second protruding part, and between the second heat dissipation strip and the second conductive strip. The second heat dissipation strip and the second protruding part are insulated from each other through the insulation layer, and the second heat dissipation strip and the second conductive strip are insulated from each other through the insulation layer. In this way, a short circuit is prevented between different second conductive strips.

In some embodiments of this application, the power module further includes a first heat dissipation layer. The first heat dissipation layer is disposed between the first power transistor and the first conductive plate, where the first conductive plate is electrically connected to the first electrode of the first power transistor through the first heat dissipation layer. The power module further includes a second heat dissipation layer. The second heat dissipation layer is disposed between the second power transistor and the second conductive plate, where the second conductive plate is electrically connected to the first electrode of the second power transistor through the second heat dissipation layer. The first conductive plate is conducted with the first electrode of the first power transistor through the first heat dissipation layer, and the second conductive plate is conducted with the first electrode of the second power transistor through the second conductive plate. In addition, heat generated when the first power transistor works can be dissipated through the first heat dissipation layer, so that a heat dissipation effect of the first power transistor is improved. Similarly, the heat dissipation layer also can improve a heat dissipation effect of the second power transistor. In this way, a thermal reliability failure caused by a high heat flux density inside the power module is improved.

In some embodiments of this application, the power module includes a plurality of first power transistors connected to each other in parallel; and/or the power module includes a plurality of second power transistors connected to each other in parallel. For example, the power module includes a plurality of first power transistors connected to each other in parallel; or the power module includes a plurality of second power transistors connected to each other in parallel; or the power module includes a plurality of first power transistors connected to each other in parallel and a plurality of second power transistors connected to each other in parallel. Total resistance of the circuit is reduced through the plurality of first power transistors connected to each other in parallel or the plurality of second power transistors connected to each other in parallel, so that a magnitude of a current converged on the second conductive plate is increased.

In some embodiments of this application, the power module further includes a drive module. The drive module is electrically connected to a control end of the first power transistor and a control end of the second power transistor. The drive module is configured to control turn-on or turn-off of the first power transistor and the second power transistor. The drive module outputs a control signal to the control end of the first power transistor or the control end of the second power transistor, and cyclically controls conduction and cut-off of the current that flows through the first power transistor or the second power transistor, so that a direction of the current transmitted to the second conductive plate cyclically changes, and a direct current is converted into an alternating current and transmitted to the second terminal.

In some embodiments of this application, both the first terminal and the second terminal are disposed on a side that is of the first power transistor and the second power transistor that is away from the drive module. In this way, the first terminal, the second terminal, and the drive module are disposed on two sides of the first power transistor and the second power transistor, and neither the first terminal nor the second terminal blocks connection between the drive module and the first power transistor and connection between the drive module and the second power transistor. That is, the drive module does not need to perform spatial avoidance on the first terminal and the second terminal, so that an overall layout of the power module can be optimized. This helps reduce a size of the power module and reduce costs.

According to a second aspect of the embodiments of this application, a power device is provided, including a circuit board and the power module in any one of the foregoing embodiments. The circuit board includes a first electrode plate and a second electrode plate that are stacked with each other. Both the first terminal and the third terminal of the power module are disposed between the first electrode plate and the second electrode plate. The foregoing power device has a same technical effect as the power module provided in the foregoing embodiments. Details are not described herein again.

In some embodiments of this application, the power module further includes an insulation layer and a fastening member. The insulation layer is disposed between the first terminal and the third terminal, and is connected to the first terminal and the third terminal. The insulation layer may be provided with a first connection hole that penetrates the insulation layer. The first terminal is provided with a second connection hole that penetrates the first terminal. The first connection hole communicates with the second connection hole, and the second connection hole is exposed from the first connection hole. The third terminal is provided with a third connection hole that penetrates the third terminal. The first connection hole communicates with the third connection hole, and the third connection hole is exposed from the first connection hole. The fastening member is disposed in the first connection hole, one end of the fastening member passes through the second connection hole and is connected to the first terminal and the first electrode plate, and the other end of the fastening member passes through the third connection hole and is connected to the third terminal and the second electrode plate. The first electrode plate and the first terminal may be fastened relative to each other via the fastening member disposed in the first connection hole and the second connection hole. In addition, the second electrode plate and the third terminal may also be fastened relative to each other via the fastening member, so that after the first electrode plate abuts against the first terminal, the first electrode plate is electrically connected to the first terminal.

### BRIEF DESCRIPTION OF DRAWINGS

FIG. 1A is a diagram of a structure of a vehicle according to an embodiment of this application;
FIG. 1B is a diagram of another structure of a vehicle according to an embodiment of this application;
FIG. 1C is a diagram of still another structure of a vehicle according to an embodiment of this application;
FIG. 2A is a diagram of a structure of a power device according to an embodiment of this application;
FIG. 2B is a circuit diagram of a power device according to an embodiment of this application;
FIG. 3 is a diagram of a structure of a first power module according to an embodiment of this application;
FIG. 4 is a sectional view of FIG. 3 in an O₁-O₂ direction;
FIG. 5 is a diagram of connection of a bonding wire structure;
FIG. 6 is a bottom view of FIG. 3 in a Z direction;
FIG. 7 is a sectional view of a second power module according to an embodiment of this application;
FIG. 8 is a diagram of a structure of a second power module according to an embodiment of this application;
FIG. 9 is a bottom view of FIG. 8 in a Z direction;
FIG. 10 is a sectional view of a third power module according to an embodiment of this application;
FIG. 11 is a sectional view of another power device according to an embodiment of this application;
FIG. 12 is a sectional view of a fourth power module according to an embodiment of this application;
FIG. 13 is a diagram of a structure of a fifth power module according to an embodiment of this application;
FIG. 14 is a sectional view of a sixth power module according to an embodiment of this application;
FIG. 15 is a sectional view of a seventh power module according to an embodiment of this application;
FIG. 16 is a sectional view of an eighth power module according to an embodiment of this application;
FIG. 17A is an assembly diagram of a first power transistor and a first conductive strip according to an embodiment of this application;
FIG. 17B is a partial sectional view of a ninth power module at a joint between a first power transistor and a second conductive plate according to an embodiment of this application;
FIG. 17C is a sectional view of FIG. 17B in a P₁-P₂ direction;
FIG. 18A is an assembly diagram of a second power transistor and a second conductive strip according to an embodiment of this application;
FIG. 18B is a partial sectional view of a tenth power module at a joint between a second power transistor and a third conductive plate according to an embodiment of this application;
FIG. 18C is a sectional view of FIG. 18B in a Q₁-Q₂ direction;
FIG. 19 is a sectional view of an eleventh power module according to an embodiment of this application; and
FIG. 20 is a diagram of a structure of a twelfth power module according to an embodiment of this application.

### Reference numerals:

100: vehicle; 01: battery; 02: power device; 03: load; 10: power module; 20: circuit board; 21: first electrode plate; 22: second electrode plate; 30: fastening member; 101: first terminal; 1011: second connection hole; 102: third terminal; 1021: third connection hole; 103: second terminal; 1031: fifth connection hole; 104: first conductive plate; 1041: avoidance hole; 1042: first body part; 105: second conductive plate; 1051: third body part; 1052: first protruding part; 106: first power transistor; 1061: first electrode of the first power transistor; 1062: second electrode of the first power transistor; 1063: control end of the first power transistor; 107: second power transistor; 1071: first electrode of the second power transistor; 1072: second electrode of the second power transistor; 1073: control end of the second power transistor; 108: third conductive plate; 1081: second protruding part; 109: fourth conductive plate; 1091: second body part; 110: first conductive pillar; 111: insulation layer; 1111: first connection hole; 1112: fourth connection hole; 112: first conductive strip; 113: second conductive strip; 114: first heat dissipation layer; 115: second heat dissipation layer; 116: drive module; 117: second conductive pillar; 118: first heat dissipation strip; and 119: second heat dissipation strip.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

In the following description, the terms "first", "second", "third", "fourth", and "fifth" are merely used for a purpose of description, and cannot be understood as an indication or an implication of relative importance or an implicit indication of a quantity of indicated technical features. Therefore, a feature limited by "first", "second", "third", "fourth" "fifth", or the like may explicitly or implicitly include one or more features. In the descriptions of this application, unless otherwise stated, "a plurality of" means two or more than two.

In this application, unless otherwise clearly specified and limited, a term "connection" should be understood in a broad sense. For example, the "connection" may be a fixed mechanical connection, or may be a detachable mechanical connection or an integrated connection, or may be a direct connection or an indirect connection implemented through an intermediate medium.

In embodiments of this application, the term like "example" or "for example" is used to represent giving an example, an illustration, or a description. Any embodiment or design scheme described as "example" and "for example" in embodiments of this application should not be explained as being more preferred or having more advantages than another embodiment or design scheme. Exactly, using of the word "example" or " for example" or the like is intended to present a relative concept in a specific manner.

In the accompanying drawings of embodiments of this application, a component is represented by using a guide line with an arrow, a component is represented by using only a guide line, and a hollow-out structure such as a cavity or an opening is represented by using a curve guide line.

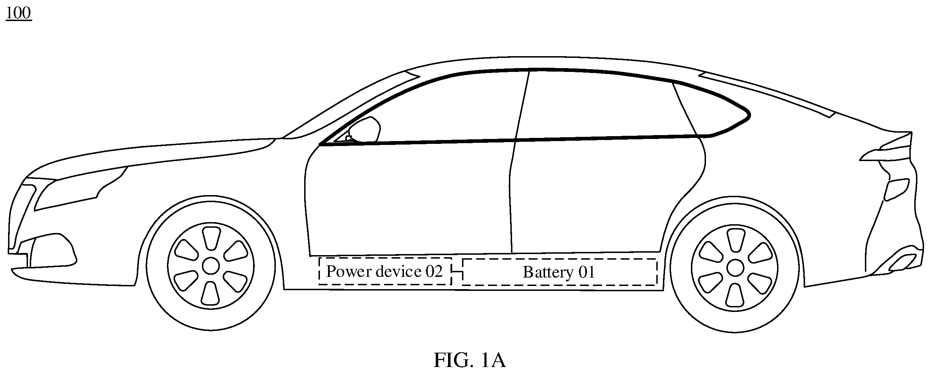

An embodiment of this application provides a vehicle 100. As shown in FIG. 1A, the vehicle 100 may include a battery 01 and a power device 02 electrically connected to the battery 01.

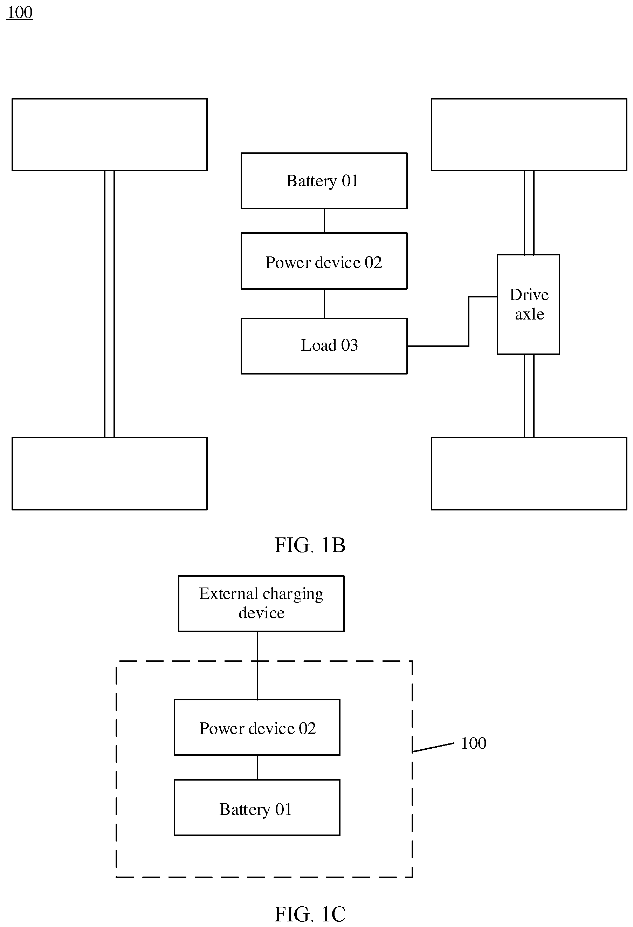

For example, the power device 02 may include an inverter. As shown in FIG. 1B, the battery 01 outputs a direct current to the power device 02, and the power device 02 is configured to: convert the direct current of the battery 01 into an alternating current, and then transmit the alternating current to a load 03, so that the load 03 works. For example, the load 03 is a motor. After the alternating current is transmitted to the motor, the motor drives a drive axle to work, so as to drive the vehicle to travel. In this case, the power device 02 may be a vehicle-mounted microcontroller unit (MCU) or a bidirectional on-board charger (OBC).

In another example, the power device 02 may include a rectifier. As shown in FIG. 1C, an external charging device (not shown in the figure) outputs an alternating current to the power device 02, and the power device 02 is configured to: convert the alternating current of the external charging device (not shown in the figure) into a direct current and transmit the direct current to the battery 01, to charge the battery 01. In this case, the power device 02 may be an on-board charger.

The foregoing uses an example in which the power device 02 is used in the vehicle 100. In another embodiment of this application, the power device 02 may be further configured to: in an energy storage system (for example, a photovoltaic system or site energy), convert a direct current of the battery 01 into an alternating current for output, or convert an alternating current into a direct current and transmit the direct current to the battery 01, to charge the battery 01.

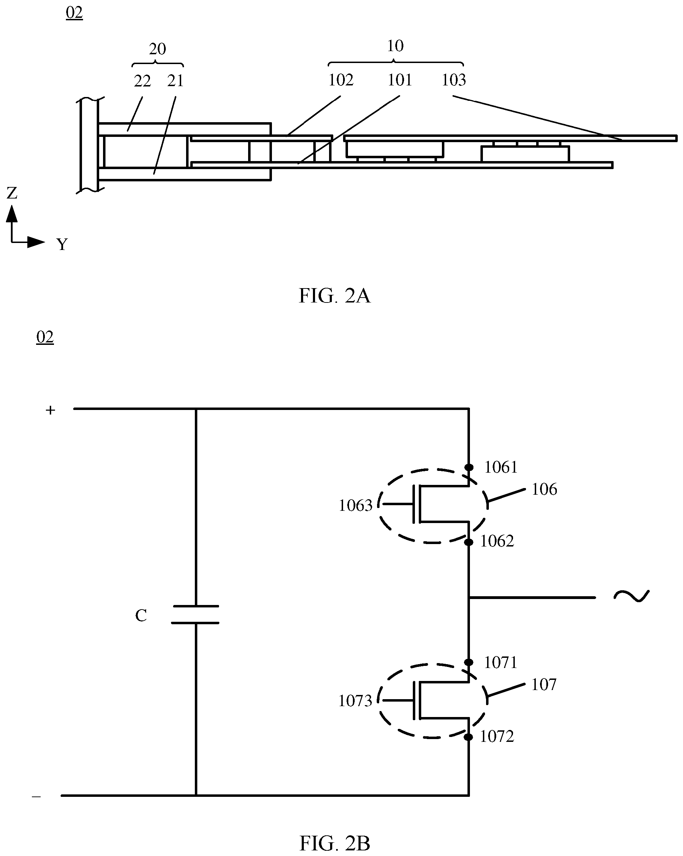

The following describes a structure of the power device 02 by using an example. For ease of description, an example in which a width extension direction of the power module 10 is an X direction, a length extension direction is a Y direction, and a thickness extension direction is a Z direction is used. As shown in FIG. 2A, the power device 02 may include a power module 10 and a circuit board 20. The power module 10 may have a first terminal 101, a third terminal 102, and a second terminal 103. The circuit board 20 may include a first electrode plate 21 and a second electrode plate 22. One end of the first electrode plate 21 is electrically connected to the first terminal 101, and the other end of the first electrode plate 21 is electrically connected to the battery 01 (as shown in FIG. 1A). One end of the second electrode plate 22 is electrically connected to the third terminal 102, and the other end of the second electrode plate 22 is electrically connected to the battery 01. A positive electrode of the battery 01 may be electrically connected to the first terminal 101 through the first electrode plate 21, and a negative electrode of the battery 01 may be electrically connected to the third terminal 102 through the second electrode plate 22. Alternatively, a positive electrode of the battery 01 may be electrically connected to the third terminal 102 through the second electrode plate 22, and a negative electrode of the battery 01 may be electrically connected to the first terminal 101 through the first electrode plate 21. After a direct current is converted into an alternating current via the power module 10, the alternating current is transmitted to the load 03 through the second terminal 103 (as shown in FIG. 1B). Alternatively, an alternating current is transmitted to the second terminal 103 via the external charging device, and after the alternating current is converted into a direct current via the power module 10, the direct current is transmitted to the battery 01 through the first terminal 101 and the third terminal 102, to charge the battery 01.

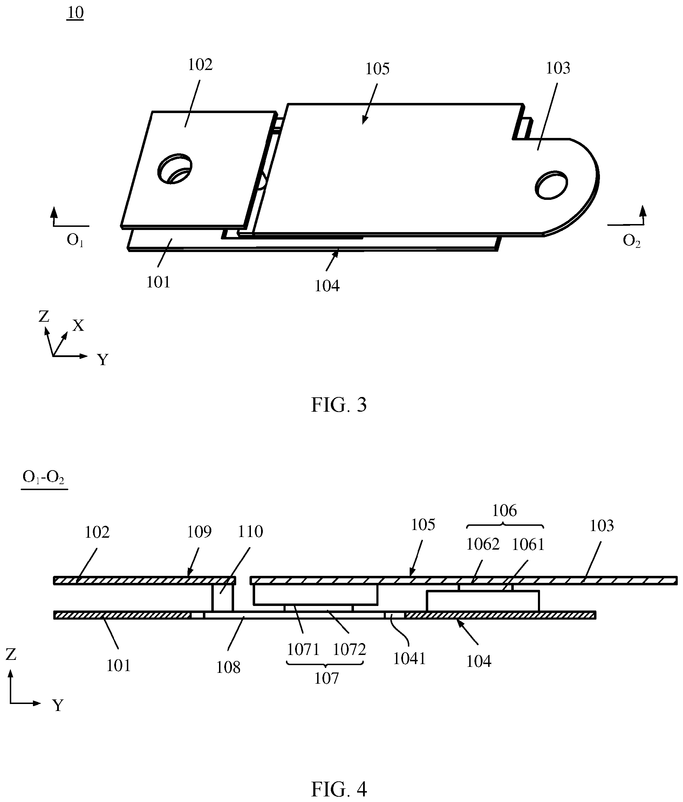

As shown in FIG. 3, the power module 10 may further include a first conductive plate 104 and a second conductive plate 105. A part of the first conductive plate 104 may serve as the first terminal 101. The second conductive plate 105 and the first conductive plate 104 may be stacked, and a part of the second conductive plate 105 may serve as the second terminal 103. As shown in FIG. 4, the power module 10 may further include a first power transistor 106 and a second power transistor 107. A first electrode 1061 of the first power transistor is electrically connected to the first conductive plate 104, and a second electrode 1062 of the first power transistor is electrically connected to the second conductive plate 105. A first electrode 1071 of the second power transistor is electrically connected to the second conductive plate 105, and a second electrode 1072 of the second power transistor is electrically connected to the third terminal 102.

When the power module 10 works, after the power module 10 converts a direct current into an alternating current, the alternating current is output to the load 03 through the second terminal 103 (as shown in FIG. 1B). Alternatively, an alternating current is input to the second terminal 103 via the external charging device, and after the alternating current is converted into a direct current via the power module 10, the direct current is input to the battery 01 through the first terminal 101 and the third terminal 102, to charge the battery 01.

Specifically, as shown in FIG. 2A and FIG. 2B, the first conductive plate 104, as a part of the first terminal 101, receives a current from the positive electrode of the battery 01 (as shown in FIG. 1B). When the first power transistor 106 is turned on, the current is transmitted to the first electrode 1061 of the first power transistor through the first conductive plate 104, and after passing through the first power transistor 106, is transmitted to the second conductive plate 105 through the second electrode 1062 of the first power transistor, that is, the current is transmitted to the second terminal 103. When the second power transistor 107 is turned on, the current is transmitted to the first electrode 1071 of the second power transistor through the second conductive plate 105, and after passing through the second power transistor 107, is transmitted to the third terminal 102 through the second power transistor 107, and finally flows back to the negative electrode of the battery 01. When the first power transistor 106 and the second power transistor 107 are alternately turned on, an alternating current is finally output through the second terminal 103.

Alternatively, in another embodiment of this application, the positive electrode of the battery 01 inputs a direct current to the second power transistor 107 through the third terminal 102. When the second power transistor 107 is turned on, the direct current is transmitted to the second conductive plate 105 through the first electrode 1061 of the first power transistor after passing through the second power transistor 107, that is, the direct current is transmitted to the second terminal 103. When the first power transistor 106 is turned on, the current is transmitted to the second electrode 1062 of the first power transistor through the second conductive plate 105, and is transmitted to the first conductive plate 104 through the first electrode 1061 of the first power transistor. Finally, the current flows back to the negative electrode of the battery 01 through the part, as the first terminal 101, of the first conductive plate 104. Similarly, when the first power transistor 106 and the second power transistor 107 are alternately turned on, an alternating current is finally output through the second terminal 103.

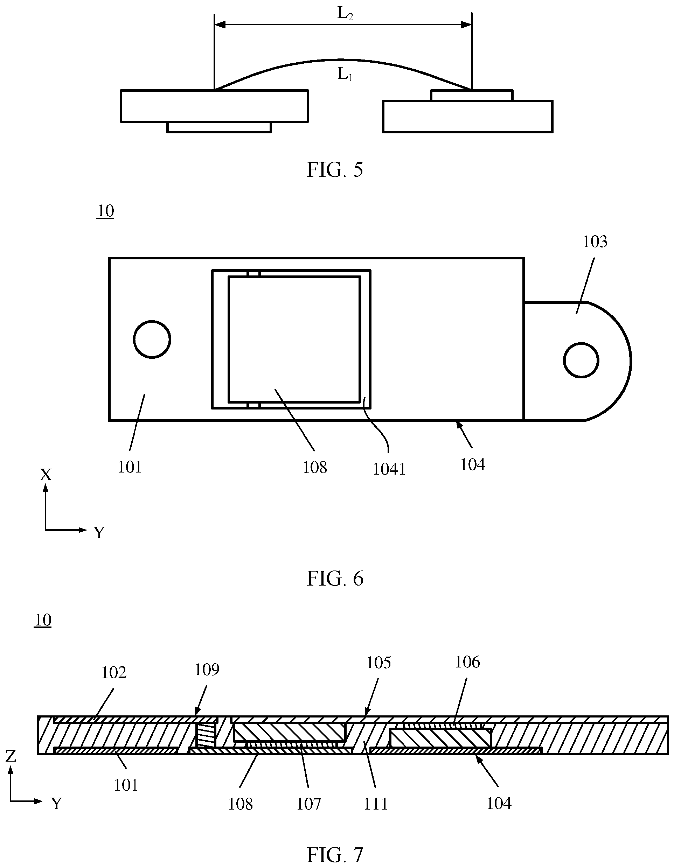

In any of the foregoing embodiments, a current needs to flow between the first power transistor 106 and the second power transistor 107. However, as shown in FIG. 5, when the first power transistor 106 and the second power transistor 107 are connected to each other through a bonding wire, because the bonding wire used in a process is usually of a curve structure, a length L1 of the bonding wire is greater than a straight-line distance L2 between two connection points. Therefore, in a connection manner using a bonding wire, the bonding wire is long, and a path of a current passing through the bonding wire is long, resulting in large parasitic inductance.

In the power module 10 provided in this embodiment of this application, the second electrode 1062 of the first power transistor is electrically connected to the first electrode 1071 of the second power transistor through the second conductive plate 105. In this case, most of the current flows between a joint between the second electrode 1062 of the first power transistor and the second conductive plate 105 and a joint between the first electrode 1071 of the second power transistor and the second conductive plate 105. That is, most of the current flows in a vertical path between the joint between the second electrode 1062 of the first power transistor and the second conductive plate 105 and the joint between the first electrode 1071 of the second power transistor and the second conductive plate 105. Compared with connection using a bonding wire of a curve structure, connection using the second conductive plate 105 has a shorter current path, and smaller parasitic inductance when a current flows in the second conductive plate 105 of a plate-shaped structure. In this way, the parasitic inductance of the power module 10 is reduced, and a voltage stress of a semiconductor element is reduced, to prevent the first power transistor 106 or the second power transistor 107 from being damaged due to excessively large voltage pressure, and improve reliability of the power module 10.

For example, the first electrode 1061 of the first power transistor may be a drain or a collector, and the second electrode 1062 of the first power transistor may be a source or an emitter. For example, the first electrode 1071 of the second power transistor may be a drain or a collector, and the second electrode 1072 of the second power transistor may be a source or an emitter.

The following further describes a structure of the power module 10 by using an example. Still as shown in FIG. 3 and FIG. 4, the third terminal 102 is located on a side that is of the first conductive plate 104 and that faces the second conductive plate 105, and is insulated from the second conductive plate 105. The third terminal 102 is stacked with the first terminal 101. In addition, the third terminal 102 is insulated from the second conductive plate 105, to prevent a short circuit caused by direct transmission of a current from the second conductive plate 105 to the third terminal 102 without passing through the second power transistor 107. In addition, the first terminal 101 is stacked with the third terminal 102. Compared with a structure in which the first terminal 101 and the third terminal 102 are located in different areas in a direction parallel to the first conductive plate 104, a structure in which the first terminal 101 is stacked with the third terminal 102 occupies smaller space in the direction parallel to the first conductive plate 104. In this way, a width of the power module 10 can be reduced, to optimize a structural layout of the power module 10 and reduce a size of the power module 10.

On this basis, still as shown in FIG. 3 and FIG. 4, the first power transistor 106 may be disposed between the first conductive plate 104 and the second conductive plate 105. The second power transistor 107 may also be disposed between the first conductive plate 104 and the second conductive plate 105. A vertical projection of the first power transistor 106 on the second conductive plate 105 does not overlap a vertical projection of the second power transistor 107 on the second conductive plate 105. Compared with that in a structure in which the second power transistor 107 and the first power transistor 106 are respectively disposed on two sides of the second conductive plate 105, in a structure in which the first power transistor 106 and the second power transistor 107 are disposed between the first conductive plate 104 and the second conductive plate 105, a thickness of the power module 10 is greater than or equal to a total thickness of the second power transistor 107, the second conductive plate 105, the first power transistor 106, and the first conductive plate 104. However, in this embodiment of this application, both the second power transistor 107 and the first power transistor 106 are disposed between the first conductive plate 104 and the second conductive plate 105, and the vertical projection of the first power transistor 106 on the second conductive plate 105 does not overlap the vertical projection of the second power transistor 107 on the second conductive plate 105, that is, a thickness of the first power transistor 106 coincides with a thickness of the second power transistor 107, so that a total thickness of the power module 10 can be reduced. In addition, the vertical projection of the first power transistor 106 on the second conductive plate 105 does not overlap the vertical projection of the second power transistor 107 on the second conductive plate 105, that is, the second power transistor 107 and the first power transistor 106 are located at different positions between the first conductive plate 104 and the second conductive plate 105, so that thermal coupling between a wafer of the second power transistor 107 and a wafter of the first power transistor 106 can be reduced. In this way, heat generated when the second power transistor 107 and the first power transistor 106 work is prevented from being accumulated, and a thermal reliability failure caused by a high heat flux density is further avoided.

Further, as shown in FIG. 6, in some embodiments of this application, the power module 10 may further include a third conductive plate 108. The second electrode 1072 of the second power transistor is electrically connected to the third conductive plate 108. The first conductive plate 104 may be provided with an avoidance hole 1041 that penetrates the first conductive plate 104, the third conductive plate 108 is disposed in the avoidance hole 1041, and the third conductive plate 108 is insulated from the first conductive plate 104. Still as shown in FIG. 4, the power module 10 may further include a third terminal 102. The third terminal 102 may be stacked with the first conductive plate 104, and is electrically connected to the third conductive plate 108. The third terminal 102 is insulated from the second conductive plate 105. In this case, after the second electrode 1072 of the second power transistor is electrically connected to the third conductive plate 108, the second power transistor 107, the third conductive plate 108, and the third terminal 102 are connected to each other, so that the second electrode 1072 of the second power transistor is electrically connected to the third terminal 102. In addition, the third conductive plate 108 is insulated from the first conductive plate 104, to prevent a short circuit caused by direct transmission of a current from the first conductive plate 104 to the third terminal 102 through the third conductive plate 108 without passing through the first power transistor 106 and the second power transistor 107. On this basis, still as shown in FIG. 4, the second power transistor 107 may be located on a side that is of the first power transistor 106 and that faces the third terminal 102. In this case, the second power transistor 107 is located between the first power transistor 106 and the third terminal 102, and a current is transmitted from the first power transistor 106 to the second conductive plate 105. The current is further transmitted to the third terminal 102 through the second power transistor 107 after passing through the second conductive plate 105, or the current is transmitted from the third terminal 102 to the second conductive plate 105 through the second power transistor 107. The current is further transmitted to the first power transistor 106 through the second conductive plate 105. In this case, the current needs to pass through the second power transistor 107. When the second power transistor 107 through which the current flows is located between the first power transistor 106 and the third terminal 102, a total current path is short, so that parasitic inductance is reduced and reliability of the power module 10 is improved. In some embodiments of this application, still as shown in FIG. 4, the power module 10 may further include a first conductive pillar 110. The first conductive pillar 110 may be disposed between the third terminal 102 and the third conductive plate 108, where two ends of the first conductive pillar 110 are electrically connected to the third terminal 102 and the third conductive plate 108 respectively. The first conductive pillar 110 is disposed on a side that is of the third conductive plate 108 and that is away from the first conductive plate 104, so that a distance between the third conductive plate 108 and the third terminal 102 is increased. In other words, a distance between the third terminal 102 and the first conductive plate 104 in a thickness direction of the power module 10 is increased, so that there may be a gap between the third terminal 102 and the first conductive plate 104, and direct electrical connection between the third terminal 102 and the first conductive plate 104 is avoided.

To provide better electrical insulation protection for the power module 10, as shown in FIG. 7, the power module 10 may further include an insulation layer 111. The insulation layer 111 may be disposed between the first conductive plate 104 and the second conductive plate 105, and between the first terminal 101 and the third terminal 102, where at least a part of the first terminal 101 and at least a part of the third terminal 102 are exposed from the insulation layer. A part that is of the first terminal 101 and that is exposed from the insulation layer 111 is configured to connect to the first electrode plate 21 (as shown in FIG. 2A). A part that is of the third terminal 102 and that is exposed from the insulation layer 111 is configured to connect to the second electrode plate 22 (as shown in FIG. 2A). Through the insulation layer 111, insulation between the first terminal 101 and the third terminal 102 is ensured, and electrical insulation protection is provided for a peripheral side of the first power transistor 106 and a peripheral side of the second power transistor 107. That is, the insulation layer 111 can provide good electrical insulation protection for the power module 10. In addition, the insulation layer 111 also can provide a support function to provide mechanical strength protection for the power module 10.

Further, still as shown in FIG. 7, the insulation layer 111 may be further disposed between the third conductive plate 108 and the first conductive plate 104. In addition, the insulation layer 111 is connected to the first conductive plate 104, the second conductive plate 105, the third conductive plate 108, and the third terminal 102. Through the insulation layer 111, insulation between the third conductive plate 108 and the first conductive plate 104 is ensured, and good electrical insulation protection is provided.

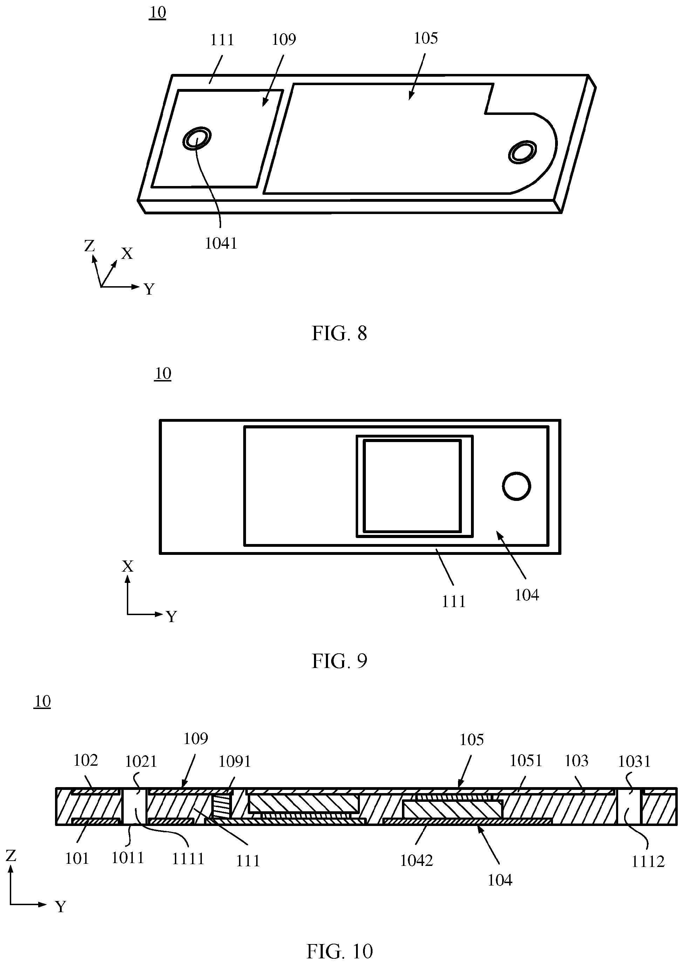

On this basis, as shown in FIG. 8 and FIG. 9, the insulation layer 111 may be further disposed on a peripheral side of the first conductive plate 104 and a peripheral side of the third terminal 102. In this case, the insulation layer 111 can ensure that the peripheral side of the first conductive plate 104 and the peripheral side of the third terminal 102 are insulated from the outside, and a creepage distance between the first conductive plate 104 and an edge part of the third terminal 102 can be increased, that is, a creepage distance between the first terminal 101 and the edge part of the third terminal 102 is increased, to prevent a creepage phenomenon. Therefore, electrical safety performance is improved, and a safety requirement is met.

Certainly, still as shown in FIG. 8, the insulation layer 111 may be further disposed on a peripheral side of the second conductive plate 105. The creepage distance of an edge part of the second conductive plate 105 is increased, to prevent a creepage phenomenon. Therefore, electrical safety performance is improved, and a safety requirement is met.

Further, as shown in FIG. 8 and FIG. 10, the insulation layer 111 may be provided with a first connection hole 1111 that penetrates the insulation layer 111. The first conductive plate 104 may include a first body part 1042 and a first terminal 101 electrically connected to the first body part 1042. The first terminal 101 may be provided with a second connection hole 1011 that penetrates the first terminal 101, the first connection hole 1111 communicates with the second connection hole 1011, and the second connection hole 1011 is exposed from the first connection hole 1111. The third terminal 102 may be provided with a third connection hole 1021 that penetrates the third terminal 102, the first connection hole 1111 communicates with the third connection hole 1021, and the third connection hole 1021 is exposed from the first connection hole 1111. In this case, the insulation layer 111 is provided with the first connection hole 1111, and the second connection hole 1011 of the first terminal 101 and the third connection hole 1021 of the third terminal 102 are exposed from the first connection hole 1111.

In some embodiments of this application, still as shown in FIG. 10, the power module 10 may further include a fourth conductive plate 109. The fourth conductive plate 109 may include a second body part 1091 and the third terminal 102 electrically connected to the second body part 1091.

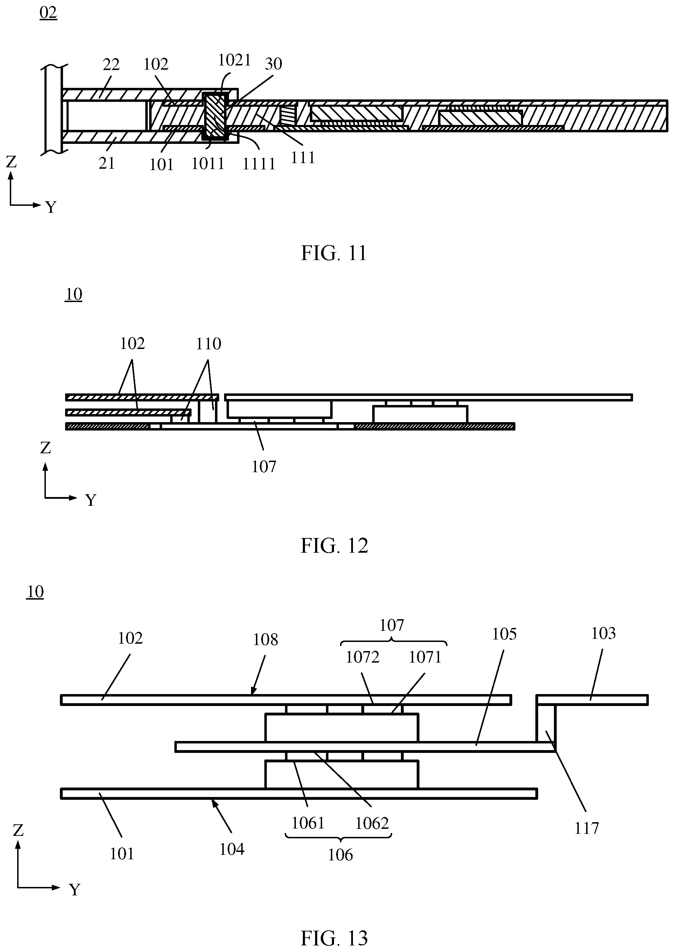

As shown in FIG. 11, the power device 02 may further include a fastening member 30, where the fastening member 30 is disposed in the first connection hole 1111, one end of the fastening member 30 passes through the second connection hole 1011, and is connected to the first terminal 101 and the first electrode plate 21, and the other end of the fastening member 30 passes through the third connection hole 1021, and is connected to the third terminal 102 and the second electrode plate 22. For example, the fastening member 30 is connected to the first terminal 101 and the third terminal 102 through the insulation layer 111. The fastening member 30 accommodated in the first connection hole 1111 supports the first terminal 101 and the third terminal 102, so as to prevent a short circuit caused by direct electrical connection between the first terminal 101 and the third terminal 102 after the first terminal 101 and the third terminal 102 are close to each other due to force applied to the power module 10. In addition, the insulation layer 111 is provided with the first connection hole 1111, and the second connection hole 1011 of the first terminal 101 and the third connection hole 1021 of the third terminal 102 are exposed from the first connection hole 1111, to ensure that two ends of the fastening member 30 disposed in the first connection hole 1111 may respectively pass through the second connection hole 1011 and the third connection hole 1021, and are respectively connected to the first terminal 101 and the third terminal 102. The first electrode plate 21 and the first terminal 101 are fastened relative to each other via the fastening member 30 disposed in the first connection hole 1111 and the second connection hole 1011, so that after the first electrode plate 21 abuts against the first terminal 101, the first electrode plate 21 is electrically connected to the first terminal 101. In addition, the second electrode plate 22 and the third terminal 102 may also be fastened relative to each other via the fastening member 30, so that after the first electrode plate 21 abuts against the first terminal 101, the first electrode plate 21 is electrically connected to the first terminal 101.

For example, still as shown in FIG. 11, the insulation layer 111 is further disposed between the fastening member 30 and the first electrode plate 21, between the fastening member 30 and the second electrode plate 22, between the fastening member 30 and the first terminal 101, and between the fastening member 30 and the third terminal 102. Through the insulation layer 111, a short circuit caused by direct electrical connection between the first electrode plate 21 and the second electrode plate 22 is prevented. Through the insulation layer 111, a short circuit caused by direct electrical connection between the first terminal 101 and the third terminal 102 is prevented.

For another example, the fastening member 30 is made of an insulation material, and the fastening member 30 is directly connected to the first electrode plate 21, the second electrode plate 22, the first terminal 101, and the third terminal 102.

In addition, as shown in FIG. 10, the second conductive plate 105 may include a third body part 1051 and a second terminal 103 electrically connected to the third body part 1051. After a direct current is converted into an alternating current via the power module 10, the alternating current can be output through the second terminal 103 of the second conductive plate 105. Alternatively, an alternating current is input to the second terminal 103, and after the alternating current is converted into a direct current via the power module 10, the direct current is output through the first terminal and the second terminal.

Still as shown in FIG. 10, the insulation layer 111 may be provided with a fourth connection hole 1112 that penetrates the insulation layer 111. The second terminal 103 may be provided with a fifth connection hole 1031 that penetrates the second terminal 103, the fourth connection hole 1112 communicates with the fifth connection hole 1031, and the fifth connection hole 1031 is exposed from the fourth connection hole 1112. The fourth connection hole 1112 is configured to accommodate a connector (not shown in the figure), and is electrically connected to the load 03 (as shown in FIG. 1B) or the external charging device via the connector.

To further reduce the parasitic inductance, as shown in FIG. 12, the power module 10 may include at least two second power transistors 107, at least two third terminals 102, and at least two first conductive pillars 110. The third terminal 102 is electrically connected to the second power transistor 107 through at least one first conductive pillar 110. When the current flows between the second power transistor 107 and the battery 01 (as shown in FIG. 1A), most of the current flows through a shortest current path in a case in which the second power transistor 107 is connected to the battery 01. In this case, different second power transistors 107 may be connected to the battery 01 through the first conductive pillar 110 and the third terminal 102 that are close to the second power transistors 107. In this way, a current path is further reduced. Therefore, the parasitic inductance is reduced and the reliability of the power module 10 is improved.

The following further describes another structure of the power module 10 by using an example. As shown in FIG. 13, the power module 10 may further include the first conductive plate 104, the second conductive plate 105, the third conductive plate 108, the first power transistor 106, and the second power transistor 107. A part of the first conductive plate 104 serves as the first terminal 101. The second conductive plate 105 is stacked with the first conductive plate 104, and the second conductive plate 105 is electrically connected to the second terminal 103. The third conductive plate 108 is stacked on a side that is of the second conductive plate 105 and that is away from the first conductive plate 104, and a part of the third conductive plate 108 serves as the third terminal 102. The first power transistor 106 may be disposed between the first conductive plate 104 and the second conductive plate 105. The first electrode 1061 of the first power transistor is electrically connected to the first conductive plate 104, and the second electrode 1062 of the first power transistor is electrically connected to the second conductive plate 105. The second power transistor 107 may be disposed between the second conductive plate 105 and the third conductive plate 108. The first electrode 1071 of the second power transistor is electrically connected to the second conductive plate 105, and the second electrode 1072 of the second power transistor is electrically connected to the third conductive plate 108.

The second electrode 1062 of the first power transistor is electrically connected to the first electrode 1071 of the second power transistor through the second conductive plate 105. In this case, most of the current flows between a joint between the second electrode 1062 of the first power transistor and the second conductive plate 105 and a joint between the first electrode 1071 of the second power transistor and the second conductive plate 105. That is, most of the current flows in a vertical path between the joint between the second electrode 1062 of the first power transistor and the second conductive plate 105 and the joint between the first electrode 1071 of the second power transistor and the second conductive plate 105. Compared with connection using a bonding wire of a curve structure, connection using the second conductive plate 105 has a shorter current path, and smaller parasitic inductance when a current flows in the second conductive plate 105 of a plate-shaped structure.

Still as shown in FIG. 13, the power module 10 may further include a second conductive pillar 117, and two ends of the second conductive pillar 117 are electrically connected to the second conductive plate 105 and the second terminal 103 respectively. The second conductive plate 105 is electrically connected to the second terminal 103 through the second conductive pillar 117.

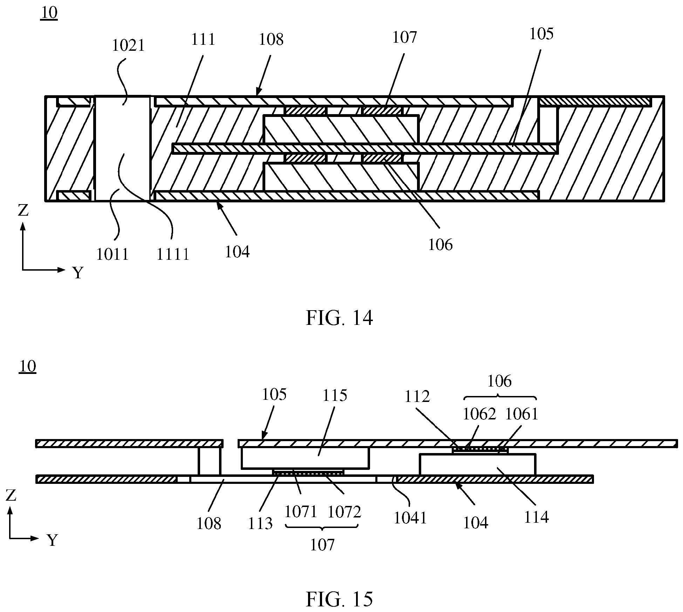

Further, as shown in FIG. 14, the power module 10 may further include the insulation layer 111. The insulation layer 111 may be disposed between the first conductive plate 104 and the second conductive plate 105, and between the first terminal 101 and the third terminal 102. At least a part of the first terminal 101 is exposed from the insulation layer 111, and is connected to the first electrode plate 21 (as shown in FIG. 2A). At least a part of the third terminal 102 is exposed from the insulation layer 111, and is connected to the second electrode plate 22 (as shown in FIG. 2A). The insulation layer 111 can provide electrical insulation protection for a peripheral side of the first power transistor 106, so as to provide good electrical insulation protection for the power module 10. In addition, the insulation layer 111 also can provide a support function to provide mechanical strength protection for the power module 10.

Still as shown in FIG. 14, the insulation layer 111 may be further disposed between the second conductive plate 105 and the third conductive plate 108. The insulation layer 111 ensures that the second conductive plate 105 is not conducted with the third conductive plate 108, and provides electrical insulation protection for a peripheral side of the second power transistor 107.

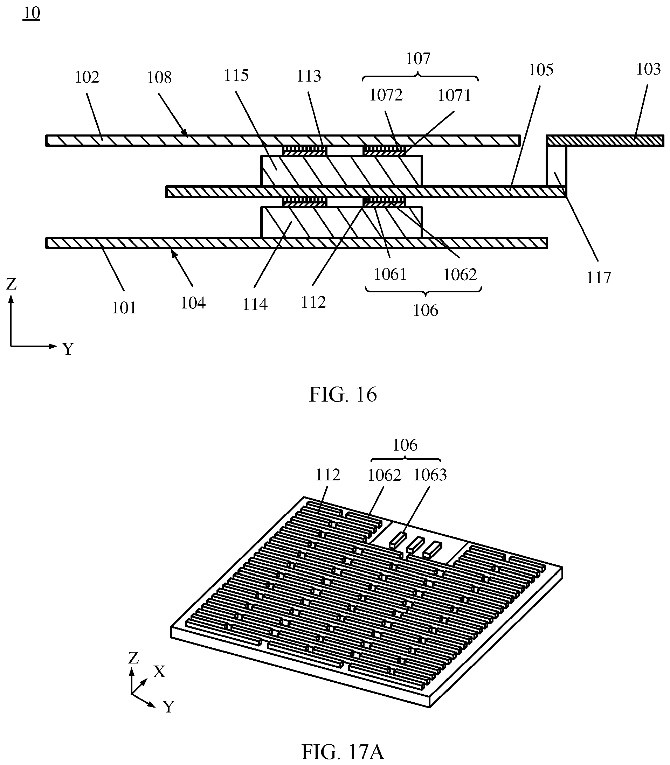

In some embodiments of this application, as shown in FIG. 15 or FIG. 16, the power module 10 may further include a plurality of first conductive strips 112. The plurality of first conductive strips 112 are sequentially spaced from each other. Each first conductive strip 112 is disposed on a side that is of the first power transistor 106 and that faces the second conductive plate 105. In addition, heat dissipated when the first power transistor 106 works may be further transmitted to the first conductive strip 112, so that heat of the first power transistor 106 is dissipated. In this way, a thermal reliability failure of the first power transistor 106 and the second power transistor 107 is improved.

As shown in FIG. 17A, the second electrode 1062 of the first power transistor is electrically connected to the second conductive plate 105 through the plurality of first conductive strips 112.

For example, still as shown in FIG. 17A, the plurality of first conductive strips 112 are arranged on the first power transistor 106 in a matrix. For another example, a material of the first conductive strip 112 includes at least one of copper and aluminum.

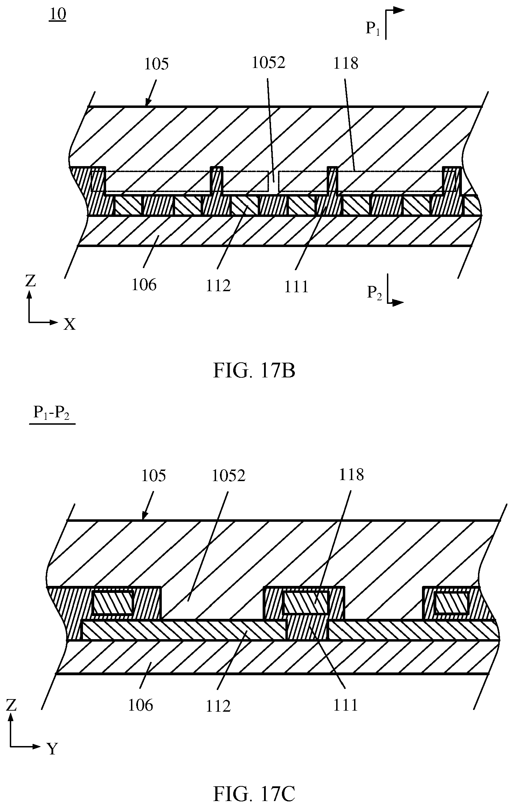

Further, as shown in FIG. 17B and FIG. 17C, an end that is of the second conductive plate 105 and that faces the first power transistor has a plurality of first protruding parts 1052, and the first protruding parts 1052 are electrically connected to the at least one first conductive strip 112. The power module further includes a plurality of first heat dissipation strips 118 located between the first conductive strip 112 and the second conductive plate 105, and the plurality of first heat dissipation strips 118 are alternately disposed between two adjacent first protruding parts 1052. The first protruding part 1052 is electrically connected to the first conductive strip 112, so that the first conductive strip 112 is electrically connected to the second conductive plate 105. Heat dissipated when the first power transistor 106 (as shown in FIG. 15) works is transferred to the first heat dissipation strip 118 disposed between two adjacent first protruding parts 1052 through the first conductive strip 112 and the insulation layer 111, and heat is dissipated through the first heat dissipation strip 118, so that a thermal reliability failure of the first power transistor is further improved.

For example, a material of the first heat dissipation strip 118 includes at least one of copper and aluminum.

Still as shown in FIG. 17B and FIG. 17C, the insulation layer 111 may be further disposed between the first heat dissipation strip 118 and the first protruding part 1052 and between the first heat dissipation strip 118 and the first conductive strip 112. The first heat dissipation strip 118 and the first protruding part 1052 are insulated from each other through the insulation layer 111, and the first heat dissipation strip 118 and the first conductive strip 112 are insulated from each other through the insulation layer 111, to prevent a short circuit between different first conductive strips 112.

For another example, during processing, a layer of insulation material is first disposed on the first power transistor 106, and then the insulation material is provided with a plurality of through holes that penetrate the insulation material. The first conductive strip 112 is formed in the through hole through electroplating or depositing. Then, a layer of insulation material is disposed on a side that is of the first conductive strip 112 and that is away from the first power transistor 106, the insulation material continues to be slotted, and the first heat dissipation strip 118 is formed in the slot through electroplating or depositing. Then, a layer of insulation material is continuously disposed on a side that is of the first heat dissipation strip 118 and that is away from the first conductive strip 112, and the insulation material is provided with a slot hole to expose the first conductive strip 112. The first protruding part 1052 of the second conductive plate 105 extends into the slot hole and is electrically connected to the first conductive strip 112.

Still as shown in FIG. 15 or FIG. 16, the power module 10 may further include a plurality of second conductive strips 113. The plurality of second conductive strips 113 are sequentially spaced from each other. Each second conductive strip 113 is disposed on a side that is of the second power transistor 107 and that faces the third conductive plate 108. In addition, heat dissipated when the second power transistor 107 works may be further transmitted to the second conductive strip 113, so that heat of the second power transistor 107 is dissipated. In this way, a thermal reliability failure of the first power transistor 106 and the second power transistor 107 is improved.

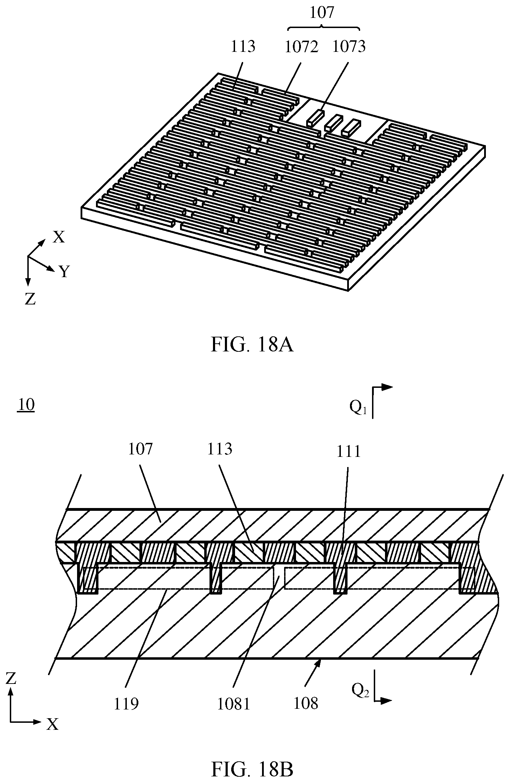

As shown in FIG. 18A, the second electrode 1072 of the second power transistor is electrically connected to the third conductive plate 108 through the plurality of second conductive strips 113.

For example, still as shown in FIG. 18A, the plurality of second conductive strips 113 are arranged on the second power transistor 107 in a matrix. For another example, a material of the second conductive strip 113 includes at least one of copper and aluminum.

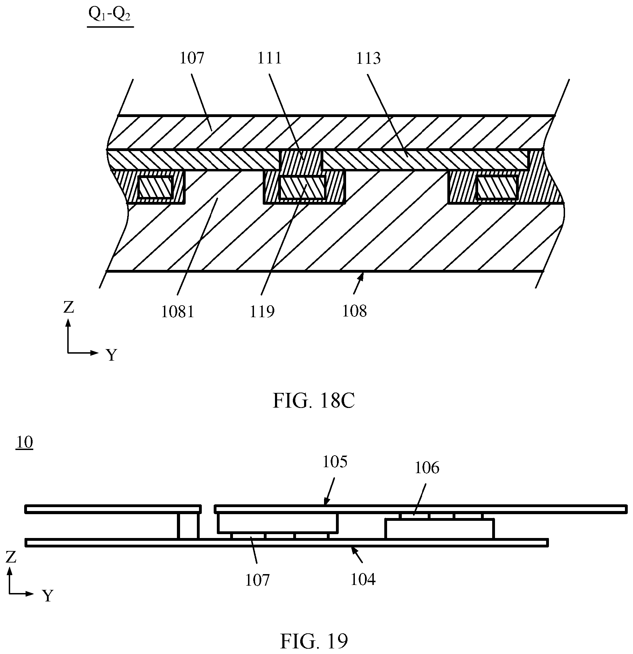

Further, as shown in FIG. 18B and FIG. 18C, an end that is of the third conductive plate 108 and that faces the second power transistor has a plurality of second protruding parts 1081, and the second protruding parts 1081 are electrically connected to the at least one second conductive strip 113. The power module further includes a plurality of second heat dissipation strips 119. The plurality of second heat dissipation strips 119 are located between the second conductive strip 113 and the third conductive plate 108, where the plurality of second heat dissipation strips 119 are alternately disposed between two adjacent second protruding parts 1081. The second protruding part 1081 is electrically connected to the second conductive strip 113, so that the second conductive strip 113 is electrically connected to the third conductive plate 108. Heat dissipated when the second power transistor 107 (as shown in FIG. 15) works is transferred to the second heat dissipation strip 119 disposed between two adjacent second protruding parts 1081 through the second conductive strip 113 and the insulation layer 111, and heat is dissipated through the second heat dissipation strip 119, so that a thermal reliability failure of the second power transistor is further improved.

For example, a material of the second heat dissipation strip 119 includes at least one of copper and aluminum.

Still as shown in FIG. 18B and FIG. 18C, the insulation layer 111 may be further disposed between the second heat dissipation strip 119 and the second protruding part 1081, and between the second heat dissipation strip 119 and the second conductive strip 113. The second heat dissipation strip 119 and the second protruding part 1081 are insulated from each other through the insulation layer 111, and the second heat dissipation strip 119 and the second conductive strip 113 are insulated from each other through the insulation layer 111. In this way, a short circuit is prevented between different second conductive strips 113.

For another example, during processing, a layer of insulation material is first disposed on the second power transistor 107, and then the insulation material is provided with a plurality of through holes that penetrate the insulation material. The second conductive strip 113 is formed in the through hole through electroplating or depositing. Then, a layer of insulation material is disposed on a side that is of the second conductive strip 113 and that is away from the second power transistor 107, the insulation material continues to be slotted, and the second heat dissipation strip 119 is formed in the slot through electroplating or depositing. Then, a layer of insulation material is continuously disposed on a side that is of the second heat dissipation strip 119 and that is away from the second conductive strip 113, and the insulation material is provided with a slot hole to expose the second conductive strip 113. The second protruding part 1081 of the third conductive plate 108 extends into the slot hole and is electrically connected to the second conductive strip 113.

It may be understood that, in the foregoing embodiment, an extending direction of the first conductive strip 112 may be any direction parallel to a surface that is of the first power transistor 106 and that faces the second conductive plate 105. Similarly, an extending direction of the second conductive strip 113 may be any direction parallel to a surface that is of the second power transistor 107 and that faces the third conductive plate 108.

To further resolve a thermal reliability failure caused by a high heat flux density inside the power module 10, still as shown in FIG. 15 or FIG. 16, the power module 10 may further include a first heat dissipation layer 114. The first heat dissipation layer 114 may be disposed between the first power transistor 106 and the first conductive plate 104, where the first conductive plate 104 is electrically connected to the first electrode 1061 of the first power transistor through the first heat dissipation layer 114. The first conductive plate 104 is conducted with the first electrode 1061 of the first power transistor through the first heat dissipation layer 114. In addition, heat generated when the first power transistor 106 works can be dissipated through the first heat dissipation layer 114, so that a heat dissipation effect of the first power transistor 106 is improved. In this way, a thermal reliability failure caused by a high heat flux density inside the power module 10 is improved.

Further, still as shown in FIG. 15 or FIG. 16, the power module 10 may further include a second heat dissipation layer 115. The second heat dissipation layer 115 may be disposed between the second power transistor 107 and the second conductive plate 105, where the second conductive plate 105 is electrically connected to the first electrode 1071 of the second power transistor through the second heat dissipation layer 115. The second conductive plate 105 is conducted with the first electrode 1071 of the second power transistor through the second conductive plate 105. In addition, heat generated when the second power transistor 107 works can be dissipated through the second heat dissipation layer 115, so that a heat dissipation effect of the second power transistor 107 is improved. In this way, a thermal reliability failure caused by a high heat flux density inside the power module 10 is improved.

In the embodiment shown in FIG. 15 or FIG. 16, an example in which the first electrode 1061 of the first power transistor and the second electrode 1062 of the first power transistor are respectively located on two sides of the first power transistor 106, and the first electrode 1071 of the second power transistor and the second electrode 1072 of the second power transistor are respectively located on two sides of the second power transistor 107 is used. In another embodiment of this application, the first electrode 1061 of the first power transistor and the second electrode 1062 of the first power transistor are respectively located on a same side of the first power transistor 106. The first heat dissipation layer 114 may be electrically connected to the first electrode 1061 of the first power transistor through a jumper or the like. Certainly, the first electrode 1071 of the second power transistor and the second electrode 1072 of the second power transistor are respectively located on a same side of the second power transistor 107. The second heat dissipation layer 115 may be electrically connected to the first electrode 1071 of the second power transistor through a jumper or the like.

In some embodiments of this application, as shown in FIG. 13 or FIG. 19, the power module 10 may include a plurality of first power transistors 106 connected to each other in parallel; and/or the power module 10 may include a plurality of second power transistors 107 connected to each other in parallel. For example, the power module 10 includes a plurality of first power transistors 106 connected to each other in parallel; or the power module 10 includes a plurality of second power transistors 107 connected to each other in parallel; or the power module 10 includes a plurality of first power transistors 106 connected to each other in parallel and a plurality of second power transistors 107 connected to each other in parallel. Total resistance of the circuit is reduced through the plurality of first power transistors 106 connected in parallel or the plurality of second power transistors 107 connected in parallel, so that a magnitude of a current converged on the second conductive plate 105 is increased.

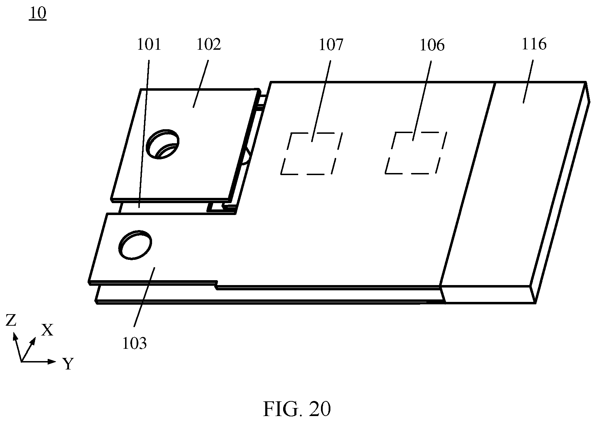

As shown in FIG. 20, the power module 10 may further include a drive module 116. The drive module 116 may be electrically connected to a control end 1063 (as shown in FIG. 17A) of the first power transistor and a control end 1073 (as shown in FIG. 18A) of the second power transistor. The drive module 116 is configured to control turn-on or turn-off of the first power transistor 106 and the second power transistor 107. The drive module 116 outputs a control signal to the control end 1063 of the first power transistor or the control end 1073 of the second power transistor, and cyclically controls conduction and cut-off of the current that flows through the first power transistor 106 or the second power transistor 107, so that a direction of the current transmitted to the second conductive plate 105 cyclically changes, and a direct current is converted into an alternating current and transmitted to the second terminal 103.

For example, the control end 1063 of the first power transistor may be a gate of the first power transistor 106. The control end 1073 of the second power transistor may also be a gate of the second power transistor 107.

Further, still as shown in FIG. 20, both the first terminal 101 and the second terminal 103 may be disposed on a side that is of the first power transistor 106 and that is of the second power transistor 107 and that is away from the drive module 116. In this way, the first terminal 101, the second terminal 103, and the drive module 116 are disposed on two sides of the first power transistor 106 and the second power transistor 107, and neither the first terminal 101 nor the second terminal 103 blocks connection between the drive module 116 and the first power transistor 106 and connection between the drive module 116 and the second power transistor 107. That is, the drive module 116 does not need to perform spatial avoidance on the first terminal 101 and the second terminal 103, so that an overall layout of the power module 10 can be optimized. This helps reduce a size of the power module 10 and reduce costs.

For example, in any one of the foregoing embodiments, the first power transistor 106 includes at least one of a metal oxide semiconductor field effect transistor (MOS), a fast recovery diode (FRD), an insulated-gate bipolar transistor (IGBT), and the like. The second power transistor 107 includes at least one of a metal oxide semiconductor field effect transistor, a fast recovery diode, an insulated gate bipolar transistor, and the like.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A power module, comprising:
a first conductive plate, wherein a part of the first conductive plate serves as a first terminal;
a second conductive plate, stacked with the first conductive plate, wherein a part of the second conductive plate serves as a second terminal;
a third terminal, located on a side that is of the first conductive plate and that faces the second conductive plate, and insulated from the second conductive plate, wherein the third terminal is stacked with the first terminal;
a first power transistor, disposed between the first conductive plate and the second conductive plate, wherein a first electrode of the first power transistor is electrically connected to the first conductive plate, and a second electrode of the first power transistor is electrically connected to the second conductive plate; and
a second power transistor, disposed on the second conductive plate, wherein a first electrode of the second power transistor is electrically connected to the second conductive plate, and a second electrode of the second power transistor is electrically connected to the third terminal.

2. The power module according to claim 1, wherein the second power transistor is disposed between the first conductive plate and the second conductive plate; and a vertical projection of the first power transistor on the second conductive plate does not overlap a vertical projection of the second power transistor on the second conductive plate.

3. The power module according to claim 2, wherein the power module further comprises:
a third conductive plate, wherein a second electrode of the second power transistor and the third terminal are electrically connected to the third conductive plate respectively, the first conductive plate is provided with an avoidance hole that penetrates the first conductive plate, the third conductive plate is disposed in the avoidance hole, and the third conductive plate is insulated from the first conductive plate.

4. The power module according to claim 3, wherein the second power transistor is located on a side that is of the first power transistor and that faces the third terminal.

5. The power module according to claim 3, wherein the power module further comprises:
a first conductive pillar, disposed between the third terminal and the third conductive plate, wherein two ends of the first conductive pillar are electrically connected to the third terminal and the third conductive plate respectively.

6. The power module according to claim 5, wherein the power module comprises at least two second power transistors, at least two third terminals, and at least two first conductive pillars, and the third terminal is electrically connected to the second power transistor through at least one first conductive pillar.

7. The power module according to claim 1, wherein the power module further comprises:
a third conductive plate, stacked on a side that is of the second conductive plate and that is away from the first conductive plate, wherein a part of the third conductive plate serves as the third terminal; and the second power transistor is disposed between the second conductive plate and the third conductive plate, the first electrode of the second power transistor is electrically connected to the second conductive plate, and the second electrode of the second power transistor is electrically connected to the third conductive plate.

8. The power module according to any one of claims 1 to 7, wherein the power module further comprises:
an insulation layer, disposed between the first conductive plate and the second conductive plate and between the first terminal and the third terminal, wherein at least a part of the first terminal and at least a part of the third terminal are exposed from the insulation layer.

9. The power module according to claim 8, wherein the power module comprises a first connection hole, and the first connection hole penetrates the first terminal, the insulation layer, and the third terminal.

10. The power module according to any one of claims 3 to 9, wherein the power module further comprises:
a plurality of first conductive strips, wherein the plurality of first conductive strips are sequentially spaced from each other, and each first conductive strip is disposed on a side that is of the first power transistor and that faces the second conductive plate; and
a plurality of second conductive strips, wherein the plurality of second conductive strips are sequentially spaced from each other, and each second conductive strip is disposed on a side that is of the second power transistor and that faces the third conductive plate.

11. The power module according to claim 10, wherein an end that is of the second conductive plate and that faces the first power transistor has a plurality of first protruding parts, and the first protruding part is electrically connected to at least one first conductive strip; and
the power module further comprises:
a plurality of first heat dissipation strips, located between the first conductive strip and the second conductive plate, wherein the plurality of first heat dissipation strips are alternately disposed between two adjacent first protruding parts.

12. The power module according to claim 10 or 11, wherein an end that is of the third conductive plate and that faces the second power transistor has a plurality of second protruding parts, and the second protruding part is electrically connected to at least one second conductive strip; and
the power module further comprises:
a plurality of second heat dissipation strips, located between the second conductive strip and the third conductive plate, wherein the plurality of second heat dissipation strips are alternately disposed between two adjacent second protruding parts.

13. The power module according to any one of claims 2 to 12, wherein the power module further comprises:
a first heat dissipation layer, disposed between the first power transistor and the first conductive plate, wherein the first conductive plate is electrically connected to the first electrode of the first power transistor through the first heat dissipation layer; and
a second heat dissipation layer, disposed between the second power transistor and the second conductive plate, wherein the second conductive plate is electrically connected to the first electrode of the second power transistor through the second heat dissipation layer.

14. The power module according to any one of claims 1 to 13, wherein the power module further comprises:
a drive module, electrically connected to a control end of the first power transistor and a control end of the second power transistor, wherein the drive module is configured to control the first power transistor and the second power transistor to be turned on or turned off; and both the first terminal and the second terminal are disposed on a side that is of the first power transistor and the second power transistor and that is away from the drive module.

15. A power device, comprising:
at least one power module according to any one of claims 1 to 14; and
a circuit board, wherein the circuit board comprises a first electrode plate and a second electrode plate that are stacked with each other, and both the first terminal and the third terminal of the power module are disposed between the first electrode plate and the second electrode plate.
